# EUROPEAN PATENT SPECIFICATION

(11) **EP 3 035 369 B1**
(45) Date of publication and mention of the grant of the patent: **25.11.2020**
(21) Application number: 14198833.7
(22) Date of filing: 18.12.2014
(51) Int. Cl.: H01L 21/311, H01L 21/768

(54) **Plasma treatment method**
Plasmabehandlungsverfahren
Procédé de traitement au plasma

(43) Date of publication of application: 22.06.2016
(73) Proprietor: IMEC VZW, 3001 Leuven (BE)
(72) Inventor: Babaei Gavan, Khashayar, 3001 Leuven (BE); Paraschiv, Vasile, 3001 Leuven (BE); Xu, Kaidong, 3001 Leuven (BE); Beyne, Eric, 3001 Leuven (BE)
(74) Representative: AWA Sweden AB

(56) References cited:
- US-A1- 2002 155 726
- US-A1- 2014 110 374
- US-B1- 6 451 705

## Description

### Technical Field

The present invention generally relates to a plasma treatment method.

### Background art

In the fabrication of semiconductor devices the formation of recesses in certain regions of semiconductor structures is essential. Methods comprising dry etching techniques such as plasma etching are commonly used to form the recesses which may for example provide contact openings in which contacts may be formed. Alternatively, the recesses may form via openings which may provide interconnect paths between conductive layers in layered semiconductor structures.

To this end, plasma etching methods such as Reactive Ion Etching, RIE, or Deep RIE has attracted significant interest in recent years when, for example, forming of Through Substrate Vias, TSVs. As a result high density integrated circuits may be manufactured providing 3D System in Package, 3D-SiP, applications. In such applications the vias may for example provide interconnections between stacked dies of either the same type or different types.

Plasma etching methods may further be used to selectively remove semiconductor layers and/or dielectric layers or portions of such layers. A reason for this is that plasma etching offers high etch rates and good uniformity of etch depth. The semiconductor layers and/or dielectric layers to be etched may for example be arranged within recesses formed in the semiconductor structures. When a layer to be etched is arranged within a recess, portions of the layer which are situated closer to the top of the recess are etched faster than portions of the layer situated closer to a bottom of the recess. This occurs due to the nature of the plasma etching process, bringing about an uneven etching, which in turn reduces the selectivity of the plasma etching. Hence there is a need for an improved plasma treatment method.

US 2014/110374 A1, US 2002/155726 A1, and US 6 451 705 B1 disclose plasma treatment methods for etching a portion of an isolating layer present on a surface of an opening in a structure.

### Summary of the invention

It is an object of the present invention to provide an improvement of the above techniques and prior art.

A particular object is to provide a plasma treatment method which allows for selective etching of a layer present in an opening of a semiconductor structure in a single plasma treatment step.

This and other objects as well as advantages that will be apparent from the following description of the present invention are achieved by a plasma treatment method according to the independent claim. Preferred embodiments are defined in the dependent claims.

By means of the invention it is possible by plasma treatment to selectively etch an isolating layer present on a surface in an opening of a semiconductor structure such that a desired portion of the layer is removed or at least partially removed during the plasma treatment while other portions of the layer remains unaffected or in principle unaffected by the plasma treatment. This is achieved by inducing a plasma in a treatment gas comprising a first component and a second component, where the first component provides forming of a protective polymer during plasma treatment and the second component provides etching of the layer during plasma treatment. More specifically, when the plasma is induced, a layer of a protective polymer or a protective polymer layer will start forming on at least portions of the isolating layer present on the external surface of the semiconductor structure and on at least portions of the isolating layer present on upper portions of sidewalls of the opening. The protective polymer being formed due to the first component of the treatment gas, will thus result in that the surfaces or portions of surfaces of the isolating layer on which the polymer is being formed will be protected or isolated from the plasma in the sense that the plasma cannot reach the surfaces or portions of surfaces of the isolating layer where the protective polymer layer is formed. However, other portions of a surface or surfaces of the isolating layer in the opening of the semiconductor structure not having any protective polymer (layer) will still be exposed to the plasma. This means that the portions of surfaces or surfaces of the isolating layer not provided with protective polymer will be etched to some extent by the second component of the treatment gas when a plasma is induced in the treatment gas. A thickness of the isolating layer may be completely etched, such that the complete thickness of the isolating layer is removed, or the thickness may be partially etched such that a thinner layer remains after the plasma treatment. In other words, a portion or portions of the isolating layer being exposed to the plasma may be completely or partially removed during the plasma treatment. Moreover, a portion or portions of the isolating layer present on a surface of the opening may be removed while another portion or portions of the isolating layer may only be slightly affected by the plasma, although being exposed to the plasma. Further, a portion or portions of the isolating layer present on another surface, such as a surface of the semiconductor structure, may only be slightly affected by the plasma, although being exposed to the plasma.

The level of etching occurring to the portions of the isolating layer not being provided with the protective polymer will depend on various parameters such as the orientation of the surface of the isolating layer. This will be described in more detail below in the detailed description section. Hence, when the plasma is induced, the forming of the protective polymer and the etching of the isolating layer will take place simultaneously as the first component and the second component are present simultaneously in the treatment gas.

It should be noted that within the context of this application the term "protective polymer" may be any polymer being formed during the plasma treatment, which polymer protects a surface or a portion of a surface on which it is being formed or provided from the plasma of the plasma treatment, meaning that the portion of the surface or the surface in question will in principle not be etched by the plasma.

It should be noted that within the context of this application the term "protective polymer layer" may be any layer formed of the protective polymer.

It should be noted that within the context of this application the term "etching" may be refer to any mechanism occurring in during the plasma treatment, where material exposed to the plasma is etched in the sense that material is removed from the material being etched.

It should be noted that within the context of this application the term "treatment gas" may be any gas in which a plasma may be induced for the purpose of treating a layer, structure or similar in the sense that the plasma affects the layer or structure itself or a material present on or in vicinity of the layer or structure during the treatment.

The treatment gas comprises C₄F₆, CH₄, C₂H₄ and/or CH₃F providing forming of a protective polymer during plasma treatment. By introducing C₄F₆, CH₄, C₂H₄ and/or CH₃F in the treatment gas a desired protective polymer is formed in a controlled manner during plasma treatment. The gases used for providing a protective polymer may be used separately or in combination during plasma treatment. Hence, the gases C₄F₆, CH₄, C₂H₄ and/or CH₃F are used to form a protective polymer layer in a controlled manner resulting in that portions of the isolating layer being provided with the protected polymer layer are protected from the plasma during plasma treatment.

The treatment gas comprises CF₄, C₄F₈, CHF₃ and/or SF₆ providing etching of the isolating layer during plasma treatment. By introducing CF₄, C₄F₈, CHF₃ and/or SF₆ in the treatment gas a desired etching of the isolating layer is achieved in a controlled manner during plasma treatment. The gases used for etching may be used separately or in combination during plasma treatment. Hence, portions of the isolating layer exposed to the plasma, i.e. not covered by protective polymer, will be etched during plasma treatment, resulting in that material of the isolating layer is removed.

A ratio of the first component and the second component of the treatment gas may be changed during the plasma treatment. By changing the ratio of the first component and the second component of the treatment gas during the plasma treatment, the amount of protective polymer being formed in relation to the etching taking place may be controlled. In other words, it will thus be possible to increase or reduce the amount of protective polymer being formed or to increase or decrease the etching speed during the plasma treatment. For instance, it may be advantageous to increase the amount of protective polymer being formed during an initial period of time during the plasma treatment. By increasing the amount of polymer being formed during an initial period of time, portions or surfaces of the isolating layer not desired to be etched may be protected from the plasma and still only exhibit little or no etching. Opposite, it may be advantageous to increase the etching speed later on during the plasma treatment, when a protective polymer layer is already formed. Further, is may be advantageous to change the ratio of the first and second components of the treatment gas during the plasma treatment in cycles, such that more protective polymer is formed during a first time period, followed by second time period exhibiting a higher etch speed, where less protective polymer is formed, and so on. The skilled person understands that the actual ratio or ratios suitable to be used during the plasma treatment will differ depending on the gases and on the plasma treatment tool used during the plasma treatment. When treating a semiconductor structure having an opening with a high depth to width aspect ratio, it may be advantageous to perform the plasma treatment in cycles as described above.

The isolating layer may comprise SiO₂, SiCO, SiN or SiCN, which is advantageous in that efficient electrical isolation between the opening and the semiconductor structure may be achieved and at the same time the material of the isolating layer may be etched during the plasma treatment.

The plasma treatment method may be a maskless method, which is advantageous in that no etch mask needs to be employed during the plasma treatment. The fact that no etch mask needs to be employed significantly reduces the complexity of the plasma treatment method. As no mask may be used, any processing steps used to introduce and subsequently remove the mask may be omitted. Moreover, problems related to alignment of a etch mask may be reduced or even eliminated. Further, the omission of an etch mask may significantly reduce the cost as well as the time for the plasma treatment method.

The isolating layer may be a conformal layer, which is advantageous in that an efficient electrical isolation between the opening and the semiconductor structure may be achieved and at the same time a well defined opening which is easy to fill subsequently, by e.g. a conductive material, may be achieved. It should be noted that within the context of this application the term "conformal layer" denotes a layer which is substantially uniform in thickness.

A depth to a width ratio of the opening may be at least 3, which is advantageous in that a desired balance between formation of a protective polymer layer and etching may be achieved. Hence, by using a depth to a width ratio of at least 3, a reasonable process window will be achieved in the sense that desired portions of the isolating layer may be etched while other portions of the isolating layer may remain substantially unaffected or unaffected by the plasma treatment. This means that desired portions of the isolating layer may be removed while other portions of the isolating layer may be unaffected or very little affected.

A width of the opening may be between 0.1 and 20 micrometers, which is advantageous in that a desired balance between formation of a protective polymer layer and etching may be achieved during plasma treatment.

The opening may be a Through Substrate Via, TSV, opening.

The plasma is induced by radio frequency power, which is advantageous in that a stable plasma having desired properties may be induced in an efficient way.

The radio frequency power comprises a low frequency component providing acceleration of ions in the plasma and a high frequency component sustaining the plasma and controlling a density of the plasma. By using two different frequency components for inducing and sustaining the plasma, the properties of the plasma may be controlled. The use of a low frequency component provides acceleration of ions in the plasma, such that a directivity of the etching of the plasma treatment method may be achieved. In other words, the low frequency component of the RF power will drive ions present in the plasma in a specific direction. This may allow for an efficient etching of a bottom surface of the opening. The use of a high frequency component sustains the plasma such that the plasma may be maintained for a desired period of time. The use of a high frequency component may further controls the density of the plasma, such that the rate of forming of protective polymer as well as etch speed may be controlled.

The term "low frequency component" refers to any frequency component in the range of 100 kHz to 4 MHz.

The term "high frequency component" refers to any frequency component in the range of 10 MHz to 100 MHz.

The treatment gas further comprises Ar, O₂, N₂ and/or CO. The use of Ar in the treatment gas may allow for a simpler and more reliable ignition of the plasma. The use of O₂, N₂ and/or CO in the plasma may allow for controlling the amount of protective polymer being formed during the plasma treatment. The presence of O₂, N₂ and/or CO in the treatment gas may result in that protective polymer layer being formed during the plasma treatment will at the same time be etched during the plasma treatment. It may thus be possible to reduce the amount of protective polymer being formed by introducing O₂, N₂ and/or CO in the treatment gas as the protective polymer will be etched while being formed. Hence, the balance between formation of the protective polymer layer and the etching speed may be further controlled by introducing O₂, N₂ and/or CO in the treatment gas. It is to be noted that O₂ generally will etch the protective polymer at a higher speed as compared to N₂ and CO, which may allow for further controlling the amount of the protective polymer being formed. The Ar, O₂, N₂ and CO gases may be used separately or in combination during the plasma treatment.

The plasma treatment method may further comprise, removing the protective polymer layer after the plasma treatment. By removing or partially removing the protective polymer layer formed during the plasma treatment, the semiconductor structure and the isolating layer may comprise no or a limited amount of protective polymer residues. Often times it is not desired to keep the protective polymer layer on the semiconductor structure and isolating layer after the plasma treatment has been completed, e.g. as the polymer will hinder or affect subsequent processing steps negatively.

The plasma treatment method may be performed using a Reactive Ion Etching, RIE, device, which is advantageous in that the plasma treatment method may be performed using standard processing tools.

### Brief Description of the Drawings

The aspects of the invention, including its particular features and advantages, will be readily understood from the following detailed description and the accompanying drawings, in which:
Figure 1 illustrates a cross-sectional side view of a semiconductor structure having an opening provided with an isolating layer.
Figure 2 illustrates a cross-sectional side view of the semiconductor structure of figure 1 after plasma treatment.
Figure 3 illustrates a cross-sectional side view of the semiconductor structure of figure 2 after removal of the protective polymer.
Figure 4 illustrates schematically the plasma treatment method for etching a layer present on a surface of an opening in a semiconductor structure.

### Detailed Description of Preferred Embodiments of the Invention

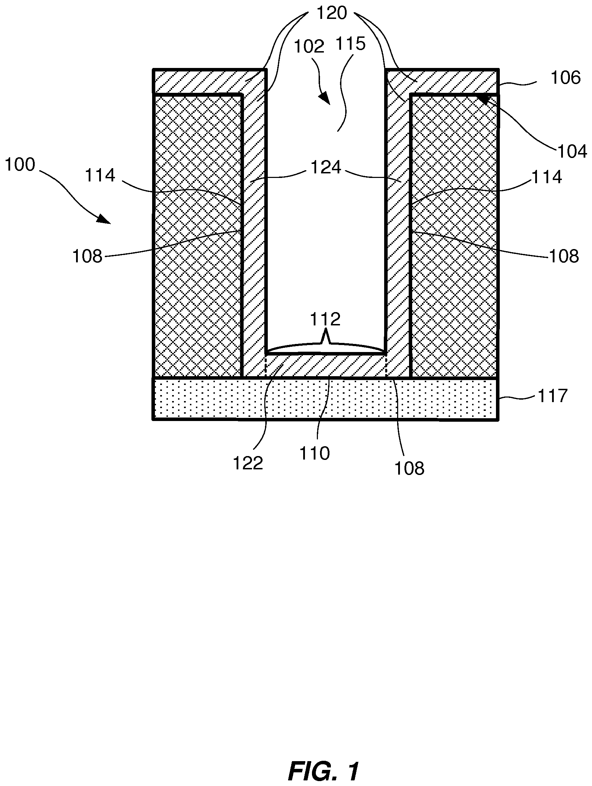

In the following a plasma treatment method for etching a layer present on a surface of an opening in a semiconductor structure is discussed with reference to the figures 1 to 3.

In figure 1 a cross-sectional side view of a semiconductor structure 100 having an opening 102 in an external surface 104 is illustrated. The opening 102 is provided with an isolating layer 106. The formation of the opening 102 may be achieved using standard process techniques known to a person skilled in the art. The opening 102 may for example be formed by plasma etching methods such as Reactive Ion Etching, RIE, or Deep RIE.

The external surface 104 of the semiconductor structure 100 and surfaces 108 defining the opening 102 are illustrated to be fully covered by the isolating layer 106. It should, however, be noted that according to other embodiments the external surface 104 of the semiconductor structure 100 and surfaces 108 defining the opening 102 may partially be covered by the isolating layer 106. However, when the isolating layer 106 is used for purposes of isolating an inner space 115 of the opening 102 from the semiconductor structure 100, sidewalls 114 of the opening 102 preferably are completely covered by the isolating layer 106 to avoid short circuit or undesired leak currents.

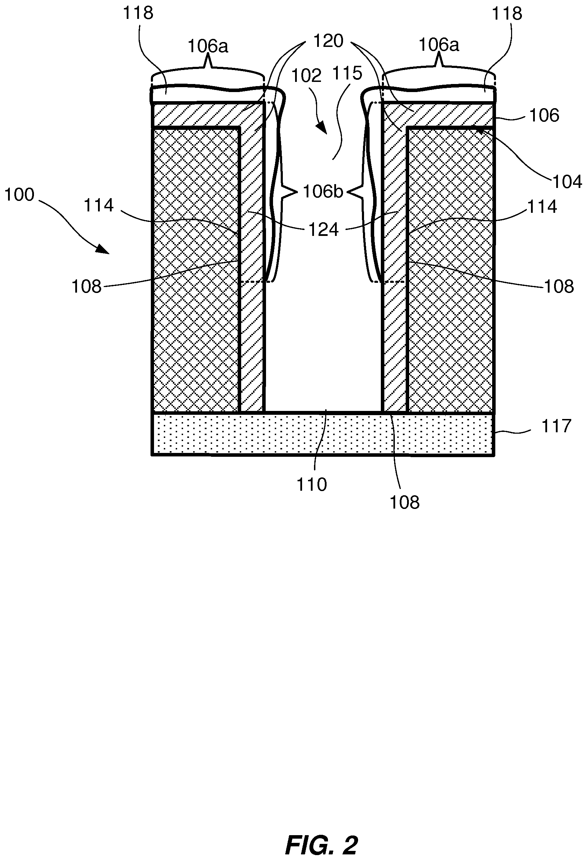

A selective etching of portions of the isolating layer 106 which are present on a bottom surface 110 of the opening 102 is now described with reference to figures 1 and 2.

By selectively removing a desired portion 112 of the isolating layer 106 the bottom surface 110 of the opening 102 is exposed while portions of the isolating layer 106 which are present on the side walls 114 of the opening 102 and on the external surface 104 of the semiconductor structure 100 are substantially unaffected by the etching, see figure 2.

The external surface 104 is in a disclosed embodiment a back side of the semiconductor structure 100 and by removing the portion 112 of the isolating layer 106, the opening 102 may form a Through Substrate Via, (TSV). To this end, the isolating layer 106 is provided as a conformal layer which is advantageous in that an efficient electrical isolation between the inner space 115 and of the opening 106 and the semiconductor structure 100 is achieved.

The semiconductor structure 100 may be a semiconductor substrate providing electrical conduction.

The use of a conformal layer further allows for a well defined opening 102 to be formed in which a contact to an adjacent layer 117 may be formed by filling the inner space 115 with a conductive material such as Cu.

The adjacent layer 117 may be a conductor or a semiconductor providing electrical conduction.

In other embodiments the adjacent layer 117 may be a semiconductor substrate which may be contacted via a contact formed in the inner space 115 of the opening 102.

To remove the portion 112 of the isolating layer 106 a plasma treatment method according to the present invention is utilized. It should be noted that the plasma treatment method here described is a maskless method which significantly reduces the complexity of the plasma treatment method compared to prior art solutions. The plasma treatment method is here performed using a RIE device or tool, but may in other embodiments be performed in other devices arranged for providing dry etching using plasma treatment.

The principles of plasma treatment are known to the skilled person in the art and will for brevity not be described in detail. It is, however, noted that the plasma is initiated and better stabilized by introducing a treatment gas comprising for example Ar to the semiconductor structure 100 and the isolating layer 106, and by applying a radio frequency, RF, electromagnetic field over the semiconductor structure 100 and the isolating layer 106. The oscillating electric field ionizes the gas molecules of the treatment gas by stripping them of electrons such that the plasma is formed. Plasma constituents such as monomers, high-energy ions and/or free radicals may be formed in the plasma and originate from components of the treatment gas, as will be described further below.

During the plasma treatment constitutes of the plasma reach the isolating layer 106 and portions of the semiconductor structure 100 not covered by the isolating layer 106 such that they alter the structure and/or shape of the material of the isolating layer 106 and possibly the semiconductor structure 100. In the following it will be described how the isolating layer 106 is affected during the plasma treatment. As known to the skilled person in the art the type of reactions that occur in the interaction with the isolating layer 106 depend sensitively on for example the pressure during the plasma treatment, the type of gases used in the treatment gas, the frequency and power of the RF electromagnetic fields as well as the geometry of the isolating layer 106 and the plasma treatment device used. In general, ions generated in the plasma will to a larger extent reach top portions 120 and bottom portions 122 of the isolating layer 106 than portions 124 of the isolating layer 106 which are adjacent to the side walls 114 of the opening 102, as the sidewalls 114 are substantially perpendicular to the trajectories of the impinging ions in the plasma. In other words, portions 124 of the isolating layer 106 present on the side walls 114 are less likely to be bombarded with ions. As a result the isolating layer 106 may be reduced in thickness or etched trough at locations within the top portion 120 of the isolating layer 106 which reduces the efficiency of the isolating layer 106 to isolate the inner space 115 of the opening 102.

To mitigate this problem a treatment gas is according to the inventive concept provided within the plasma treatment method, where the treatment gas comprises a first component providing forming of a protective polymer during the plasma treatment and a second component providing etching of the isolating layer 106 during plasma treatment.

More specifically, when the plasma is induced, the first component allows for forming of a protective polymer. The protective polymer will form a protective polymer layer 118 on portions 106a of the isolating layer 106 present on the external surface 104 of the semiconductor structure 100 and on portions 106b of the isolating layer 106 present on upper portions of sidewalls 114 of the opening 102. The protective polymer layer 118 thereby protects the portions 106a, 106b of the isolating layer 106 from the plasma such that the plasma cannot reach the portions 106a, 106b which are covered by the protective polymer layer 118.

In the plasma treatment the induced polymer deposition, i.e. the polymerization caused by the first component, depends in a complex manner on several factors such as the composition of the treatment gas in the plasma, the RF electromagnetic fields used and the geometry of sample onto which the polymer is deposited. For polymer deposition onto the isolating layer 106 present on the semiconductor structure 100, shadowing, diffusion and reflection of polymer forming plasma constituents originating from first component may further influence where and to which extent polymerization occurs. The amount of polymer formed on the isolating layer 106 inside the opening 102 depends for example on the amount of the first component and the amount of formed monomers originating from the first component that arrive at the surfaces of the isolating layer present in the opening 102. A flux of polymer forming monomers may moreover be larger at a top of the opening 102 compared to a flux at a bottom of the opening 102, e.g. at the portion 112 of the isolating layer 106 present on the bottom surface 110 of the opening 102. As a result a thickness of the formed protective polymer layer 118 may decrease as the distance from the top of the opening 102 increases.

When the polymer forming monomers come in contact with the isolating layer 106 they may remain adsorbed, polymerize and contribute to the protective polymer layer 118 being formed on the isolating layer 106. A fraction of the polymer forming monomers may also diffuse or desorb from the isolating layer 106. The polymer forming monomers are, however, highly reactive such that the probability of polymer formation is larger at the top of the opening 102 such that none or only a small fraction of the monomers will reach the bottom portion 122 of the isolating layer 106. Hence the protective polymer layer 118 is mainly formed on top portions 120 of the isolating layer 106, as shown in figure 2.

To this end, the second component which, during the plasma treatment, provides etching of the isolating layer 106, results in ions and other plasma constituents that may travel a greater distance than the monomers originating from the first component, when a plasma is induced. Hence, the second component provide ions and other plasma constituents that to a larger extent reach the bottom of the opening 106 such that the desired portion 112 of the isolating layer 106 is etched. In other words, the portion 112 of the isolating layer 106 present on the bottom surface 110 of the opening 102 is etched. According to the described embodiment the first component of the treatment gas is C₄F₆ provided in the range 20-50 sccm which allows for the protective polymer layer 118 to be formed in a controlled manner during the plasma treatment.

According to other embodiments the treatment gas may comprise CH₄, C₂H₄ and/or CH₃F for providing the forming of a protective polymer during plasma treatment.

The second component of the treatment gas is in the described embodiment CF₄, but other gases such as C₄F₈, CHF₃ and/or SF₆ may also be used for providing etching of the isolating layer 106 during the plasma treatment. The amount of CF₄ is preferably provided in the range 10-100 sccm to achieve the desired etching of the isolating layer 106.

As discussed above the nature of the plasma and the type of reactions that occur in the plasma depend sensitively on the gases present in the plasma. By tuning the ratio of the first component and the second component in the treatment gas the desired etching may be achieved as exemplified by the given ranges of the first and the second component above.

In other embodiments the ratio of the first component and the second component of the treatment gas may be changed during the plasma treatment. It is thereby possible to increase or reduce the amount of protective polymer being formed or to increase or decrease the amount of etching of the isolating layer 106 that occurs during the plasma treatment. To this end, the frequency and power of the RF electromagnetic fields may also be tuned to obtain the desired etching of the isolating layer 106 by the plasma treatment method. By using at least two RF electromagnetic fields having different frequencies the plasma may be controlled. Advantageously, a low frequency component is used to provide acceleration of charged plasma constituents such that a directivity of the etching of the plasma treatment method may be achieved. In other words, the low frequency component of the RF electromagnetic field will drive ions present in the plasma in given specific direction determined by the design of the plasma treatment device. It is thereby possible to achieve that ions and other plasma constituents reach the bottom portion 122 of the isolating layer 106 such that the portion 112 of the isolating layer 106 is etched. A high frequency component is further used to sustain and control a density of the plasma over time. This allows for tuning of the rate protective polymer being formed as well as the etch speed of the isolating layer 106.

For the described embodiment the low frequency component is preferably provided at 2 MHz with a power in the range of 300 W to 500 W and the high frequency component is preferably provided at 27 MHz with a power in the range of 700 W to 2000 W.

It should be noted that according to other embodiments the low frequency component may be any frequency component in the range of 100 kHz to 4 MHz where the suitable frequency within the range depends, for example, on the design of the plasma treatment device used. Further, the high frequency component may be any frequency component in the range of 10 MHz to 100 MHz, depending on the design of the plasma treatment device used.

The treatment gas comprises Ar, O₂, N₂ and/or CO. By providing Ar in the treatment gas ignition of the plasma is achieved, while O₂, N₂ and/or CO allow for better control of the amount of protective polymer that is formed as a protective polymer layer 118 during the plasma treatment. It is for example possible to reduce the amount of protective polymer that is formed during the plasma treatment as O₂, N₂ and CO in the treatment gas etches the protective polymer layer 118 while being formed. Hence, the balance between formation of the protective polymer layer 118 and the etching of the same may be controlled by controlling the amount of O₂, N₂ and CO in the treatment gas. It is to be noted that O₂ generally will etch the protective polymer layer 118 at a higher speed as compared to N₂ and CO, which may allow for further controlling the amount of the protective polymer layer 118 being formed. The Ar, O₂, N₂ and CO gases may be used separately or in combination in the treatment gas.

According to the described embodiment the Ar is provided in the range of 200 to 2000 sccm in the in the treatment gas and the O₂ in the range of 5 to 20 sccm to obtain the above described desired etching results of the isolating layer 106.

A pressure in a processing chamber used during the plasma treatment according to the described embodiment is furthermore preferably in the range of 25 to 150 mtorrs. Hence, according to the described embodiment, the semiconductor structure 100 and the isolating layer 106 is preferably located within the processing chamber during the plasma treatment.

The isolating layer 106 may comprise SiO₂, SiCO, SiN or SiCN, which is advantageous in that efficient electrical isolation between the inner space 115 of the opening 102 and the semiconductor structure 100 may be achieved and at the same time the material of the isolating layer 106 may be etched during the plasma treatment. The skilled person in the art realizes that the isolating layer 106 may comprise any material that is etchable by a fluorine based plasma. The material of the isolating layer 106 is preferably also chosen such that the isolating layer 106 may be formed as a conformal layer. The isolating layer 106 may be formed using standard deposition techniques known to a person skilled in the art, such as, for example, atomic layer deposition (ALD), physical vapour deposition (PVD). An isolating layer 106 which is of uniform thickness may thereby be provided. It is worth noting that the thickness of the isolating layer 106 should preferably be sufficiently thick to provide the required insulation between the inner space 115 of the opening 102 and the semiconductor structure 100, but at the same time may not be too thick, such that filling of the opening becomes problematic for example in BEOL applications.

The thickness of the isolating layer 106 may comprise portions having different thicknesses. The thickness of the isolating layer 106 present on the external surface 104 of the semiconductor structure 100 may, for example, be larger than the thickness of the isolating layer 106 present on the surfaces 108 defining the opening 102. The thickness of the isolating layer 106 present on the surfaces 108 defining the opening 102 may, however, advantageously be uniform such that a conformal isolating layer 106 may be formed within the opening 102. An efficient electrical isolation between the inner space 115 of the opening 102 and the semiconductor structure 100 may thereby be achieved.

It should further be noted that a depth to a width ratio of the opening 102 may preferable be at least 3, which is advantageous in that a desired balance between the formation of the protective polymer layer 118 and the etching of the isolating layer 106 is achieved. In other words, by using a depth to a width ratio of at least 3 the desired portion 112 of the isolating layer 106 may be etched while other portions 120, 124 of the isolating layer 106 remain substantially unaffected or unaffected by the plasma treatment. This means that the desired portion 112 of the isolating layer 106 may be removed such that the bottom surface 110 of the opening 102 is exposed, see figure 2, while other portions 120, 124 of the isolating layer 106 is unaffected or very little affected during the plasma treatment. Hence, the portion 112 of the isolating layer 106 may be completely etched, i.e. the complete thickness of the portion 112 of the isolating layer 106 is removed. Further, the thickness of the portion 112 of the isolating layer 106 may be partially etched such that a thinner portion 112 of the isolating layer 106 remains after the plasma treatment. In other words, portions of the isolating layer 106 may be completely or partially removed during the plasma treatment. Moreover, portions of the isolating layer 106 present on the bottom surface 110 of the opening 102 may be removed while portions of the isolating layer 106 present on other surfaces, such as the sidewalls 114 of the opening 102, may only be slightly affected by the plasma, although being exposed to the plasma. For clarity, etching effects on other portions of the isolating layer 106 than the portion 112 are not illustrated.

It may further be noted that for openings 102 having high depth to width aspect ratios, it may be advantageous to perform the plasma treatment in cycles as described above to efficiently remove the desired portion 112 of the isolating layer 106 present on the bottom surface 110 of the opening such that the bottom surface 110 of the opening 102 is exposed.

The width of the opening 106 may be between 0.1 and 20 micrometers, which is advantageous in that a desired balance between the formation of the protective polymer layer 118 and the etching of the isolating layer 106 may be achieved during the plasma treatment.

To summarise, in the embodiment of the present invention described above the following parameters are used to achieve the desired etching of the portion 112 of the isolating layer 106 when using a RIE tool of the make Lam^{@} RESEARCH providing RF electromagnetic fields with the frequencies 2 MHz, 27 MHz and 60 MHz:
1) Pressure in the range of 25 to 150 mtorrs.
2) Low frequency component of 2 MHz with a power in the range of 300 W to1500 W.
3) High frequency component of 27 MHz with a power in the range of 700 W to 2000 W.
4) Amount of Ar in the range of 200 to 2000 sccm.
5) Amount of O₂ in the range of 5 to 20 sccm.
6) Amount of CF₄ in the range 10 to 100 sccm.
7) Amount of C₄F₆ in the range 20 to 50 sccm.

Alternatively, a RIE tool of the make Tokyo Electron Limited (TEL) may, for example, be used for the plasma treatment, the TEL tool providing RF electromagnetic fields with the frequencies 400 kHz, 13.32 MHz and 100 MHz.

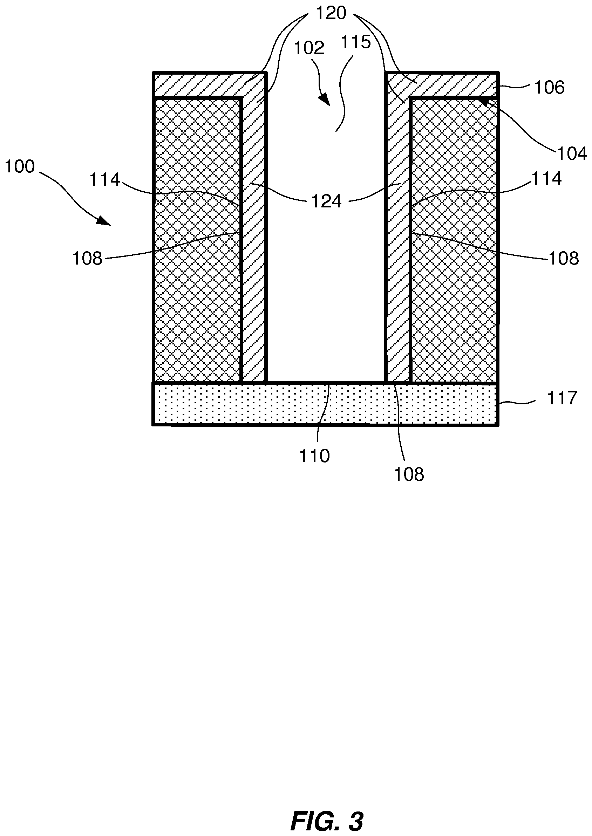

Figure 3 illustrates the semiconductor structure 100 and the isolating layer 106 after the protective polymer layer 118 has been removed by a further step in the plasma treatment method. By removing the protective polymer layer 118 formed during the plasma treatment of the semiconductor structure 100 and the isolating layer 106, no or a limited amount of protective polymer residues may be left on the on the isolating layer 106. The removing of the protective polymer layer 118 may be achieved by treating the semiconductor structure 100 and the isolating layer 106 with a oxygen based plasma. Preferable the step of removing of the protective polymer layer 118 is performed subsequent to the plasma treatment. The step of removing the protective polymer layer 118 may advantageously be performed within the same plasma treatment device or tool where the previous plasma treatment was performed. A transfer of the semiconductor structure 100 provided with the isolating layer 106 to another plasma treatment device is thereby not needed which increases the speed of the treatment of the semiconductor structure 100. Further, the protective polymer layer may be removed using any suitable technique, such as wet etching or use of a dedicated remover.

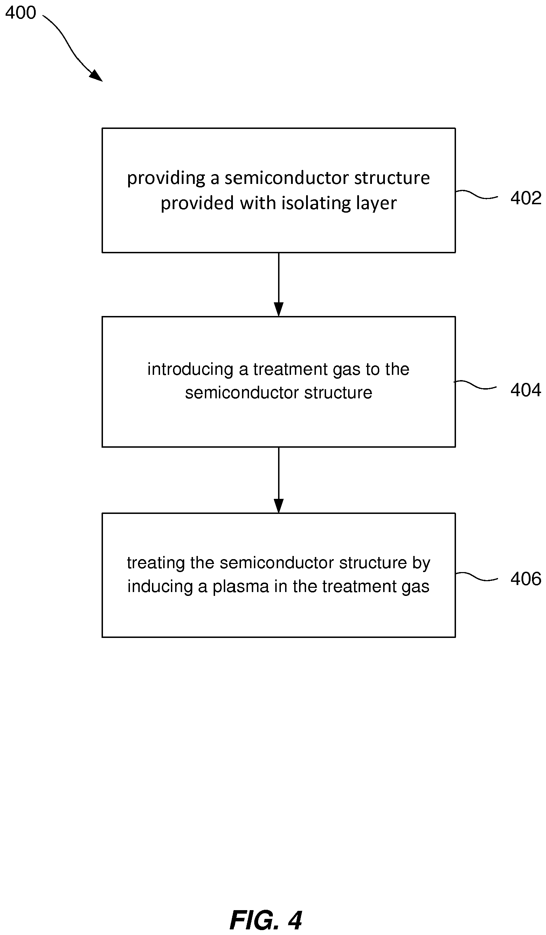

Figure 4 schematically illustrates the plasma treatment method 400 described above. As disclosed above the method 400 comprises the steps of providing 402 a semiconductor structure 100 comprising an opening 102 in an external surface 104, wherein the external surface 104 of the semiconductor structure 100 and surfaces 108 defining the opening 102 are at least partially covered by an isolating layer 106. The method 400 further comprises the step of introducing 404 a treatment gas to the semiconductor structure 100 and the isolating layer 106, the treatment gas comprising a first component providing forming of a protective polymer during plasma treatment and second component providing etching of the isolating layer 106 during plasma treatment, and the step of treating 406 the semiconductor structure 100 and the isolating layer 106 by inducing a plasma in the treatment gas, such that a protective polymer layer 118 is formed on at least portions 106a of the isolating layer 106 present on the external surface 104 of the semiconductor structure 100 and on at least portions 106b of the isolating layer 106 present on upper portions of sidewalls 114 of the opening 102, thereby protecting the portions 106a, 106b of the isolating layer 106 where the protective polymer layer 118 is being formed, from the plasma, wherein portions 112 of the isolating layer 106 being exposed to the plasma are etched.

The function and benefits of the method 400 is described above in relation figure 1 to 3 and in order to avoid undue repetition, reference is made to the above.

## Claims

1. A plasma treatment method (400) for etching a portion (112) of an isolating layer (106) present on a surface (110) of an opening in a semiconductor structure (100), the method (400) comprising:
providing (402) a semiconductor structure (100) comprising an opening (102) in an external surface (104), wherein the external surface (104) of the semiconductor structure (100) and surfaces (108,110, 114) defining the opening (102) are at least partially covered by the isolating layer (106),
introducing (404) a treatment gas to the semiconductor structure (100) and the isolating layer (106), the treatment gas comprising a first component providing forming of a protective polymer during plasma treatment and a second component providing etching of the isolating layer (106) during plasma treatment, and
treating (406) the semiconductor structure (100) and the isolating layer (106) by inducing a plasma in the treatment gas, such that a protective polymer layer (118) is formed on at least portions (106a) of the isolating layer (106) present on the external surface (104) of the semiconductor structure (100) and on at least portions (106b) of the isolating layer (106) present on upper portions of sidewalls (114) of the opening (102), thereby protecting the portions (106a, 106b) of the isolating layer (106) where the protective polymer layer (118) is being formed, from the plasma, wherein portions (112) of the isolating layer (106) being exposed to the plasma are etched,
wherein the treatment gas comprises C₄F₆, CH₄, C₂H₄ and/or CH₃F providing forming of the protective polymer during the plasma treatment, CF₄, C₄F₈, CHF₃ and/or SF₆ providing etching of the isolating layer (106) during the plasma treatment, and Ar, O₂, N₂ and/or CO, and wherein
the plasma is induced by radio frequency power, wherein the radio frequency power comprises a low frequency component providing acceleration of ions in the plasma and a high frequency component sustaining the plasma and controlling a density of the plasma, wherein the low frequency component refers to any frequency component in the range of 100 kHz to 4 MHz, and the high frequency component refers to any frequency component in the range of 10 MHz to 100 MHz.

2. Method (400) according to claim 1, wherein a ratio of the first component and the second component of the treatment gas is changed during the plasma treatment.

3. Method (400) according to any one of the preceding claims, wherein the isolating layer (106) comprises SiO₂, SiCO, SiN or SiCN.

4. Method (400) according to any one of the preceding claims, wherein the plasma treatment method (400) is a maskless method.

5. Method (400) according to any one of the preceding claims, wherein the isolating layer (106) is a conformal layer.

6. Method (400) according to any one of the preceding claims, wherein a depth to a width ratio of the opening (102) is at least 3.

7. Method (400) according to any one of the preceding claims, wherein a width of the opening (106) is between 0.1 and 20 micrometers.

8. Method (400) according to any one of the preceding claims, wherein the opening (106) is a Through Substrate Via, TSV, opening.

9. Method (400) according to any one of the preceding claims, the method (400) further comprising, removing the protective polymer layer (118) after the plasma treatment.

10. Method (400) according to any one of the preceding claims, wherein the method (400) is performed using a Reactive Ion Etching, RIE, device.

## Patentansprüche

1. Plasmabehandlungsverfahren (400) zum Ätzen eines Abschnitts (112) einer Isolierschicht (106), der auf einer Oberfläche (110) einer Öffnung in einer Halbleiterstruktur (100) vorhanden ist, wobei das Verfahren (400) folgende Schritte umfasst:
Bereitstellen (402) einer Halbleiterstruktur (100), die eine Öffnung (102) in einer externen Oberfläche (104) umfasst, wobei die externe Oberfläche (104) der Halbleiterstruktur (100) und die Oberflächen (108, 110, 114), welche die Öffnung (102) definieren, mindestens teilweise von der Isolierschicht (106) abgedeckt sind,
Einführen (404) eines Behandlungsgases in die Halbleiterstruktur (100) und die Isolierschicht (106), wobei das Behandlungsgas eine erste Komponente, die das Bilden eines Schutzpolymers während der Plasmabehandlung bereitstellt, und eine zweite Komponente, die das Ätzen der Isolierschicht (106) während der Plasmabehandlung bereitstellt, umfasst, und
Behandeln (406) der Halbleiterstruktur (100) und der Isolierschicht (106) durch Induzieren eines Plasmas in dem Behandlungsgas, so dass eine Schutzpolymerschicht (118) mindestens auf Abschnitten (106a) der Isolierschicht (106), die auf der externen Oberfläche (104) der Halbleiterstruktur (100) vorhanden sind, und mindestens auf Abschnitten (106b) der Isolierschicht (106), die auf oberen Abschnitten von Seitenwänden (114) der Öffnung (102) vorhanden sind, gebildet wird, wodurch die Abschnitte (106a, 106b) der Isolierschicht (106) dort vor dem Plasma geschützt werden, wo die Schutzpolymerschicht (118) gebildet wird, wobei die Abschnitte (112) der Isolierschicht (106), die dem Plasma ausgesetzt sind, geätzt werden,
wobei das Behandlungsgas C₄F₆, CH₄, C₂H₄ und/oder CH₃F, wodurch das Bilden des Schutzpolymers während der Plasmabehandlung bereitgestellt wird, CF₄, C₄F₈, CHF₃ und/oder SF₆, wodurch das Ätzen der Isolierschicht (106) während der Plasmabehandlung bereitgestellt wird, und Ar, O₂, N₂ und/oder CO umfasst,
und wobei das Plasma durch Funkfrequenzenergie induziert wird, wobei die Funkfrequenzenergie eine Niederfrequenzkomponente, die eine Beschleunigung von Ionen in dem Plasma bereitstellt, und eine Hochfrequenzkomponente, die das Plasma aufrechterhält und eine Dichte des Plasmas steuert, umfasst, wobei sich die Niederfrequenzkomponente auf eine beliebige Frequenzkomponente im Bereich von 100 kHz bis 4 MHz bezieht, und sich die Hochfrequenzkomponente auf eine beliebige Frequenzkomponente im Bereich von 10 MHz bis 100 MHz bezieht.

2. Verfahren (400) nach Anspruch 1, wobei ein Verhältnis zwischen der ersten Komponente und der zweiten Komponente des Behandlungsgases während der Plasmabehandlung geändert wird.

3. Verfahren (400) nach einem der vorhergehenden Ansprüche, wobei die Isolierschicht (106) SiO₂, SiCO, SiN oder SiCN umfasst.

4. Verfahren (400) nach einem der vorhergehenden Ansprüche, wobei das Plasmabehandlungsverfahren (400) ein maskenloses Verfahren ist.

5. Verfahren (400) nach einem der vorhergehenden Ansprüche, wobei die Isolierschicht (106) eine oberflächentreue Schicht ist.

6. Verfahren (400) nach einem der vorhergehenden Ansprüche, wobei ein Verhältnis von Tiefe zu Breite der Öffnung (102) mindestens 3 ist.

7. Verfahren (400) nach einem der vorhergehenden Ansprüche, wobei eine Breite der Öffnung (106) zwischen 0,1 und 20 Mikrometern liegt.

8. Verfahren (400) nach einem der vorhergehenden Ansprüche, wobei die Öffnung (106) eine Substratdurchkontaktierungs-, TSV, Öffnung ist.

9. Verfahren (400) nach einem der vorhergehenden Ansprüche, wobei das Verfahren (400) ferner das Entfernen der Schutzpolymerschicht (118) nach der Plasmabehandlung umfasst.

10. Verfahren (400) nach einem der vorhergehenden Ansprüche, wobei das Verfahren (400) unter Verwendung einer Vorrichtung zum reaktiven lonenätzen, RIE, erfolgt.

## Revendications

1. Procédé de traitement au plasma (400) pour la gravure d'une partie (112) d'une couche isolante (106) présente sur une surface (110) d'une ouverture dans une structure semi-conductrice (100), le procédé (400) comprenant :
la fourniture (402) d'une structure semi-conductrice (100) comprenant une ouverture (102) dans une surface externe (104), dans lequel la surface externe (104) de la structure semi-conductrice (100) et des surfaces (108, 110, 114) définissant l'ouverture (102) sont au moins partiellement recouvertes par la couche isolante (106),
l'introduction (404) d'un gaz de traitement dans la structure semi-conductrice (100) et la couche isolante (106), le gaz de traitement comprenant un premier composant produisant la formation d'un polymère protecteur pendant le traitement au plasma et un deuxième composant produisant la gravure de la couche isolante (106) pendant le traitement au plasma, et
le traitement (406) de la structure semi-conductrice (100) et de la couche isolante (106) en induisant un plasma dans le gaz de traitement de telle sorte qu'une couche polymère protectrice (118) est formée sur au moins des parties (106a) de la couche isolante (106) présente sur la surface externe (104) de la structure semi-conductrice (100) et sur au moins des parties (106b) de la couche isolante (106) présente sur des parties supérieures de parois latérales (114) de l'ouverture (102), en protégeant ainsi les parties (106a, 106b) de la couche isolante (106) où la couche polymère protectrice (118) est en train d'être formée par rapport au plasma, dans lequel des parties (112) de la couche isolante (106) qui sont exposées au plasma sont gravées,
dans lequel le gaz de traitement comprend du C₄F₆, CH₄, C₂H₄ et/ou CH₃F produisant la formation du polymère protecteur pendant le traitement au plasma, du CF₄, C₄F₈, CHF₃ et/ou SF₆ produisant la gravure de la couche isolante (106) pendant le traitement au plasma, et de l'Ar, O₂, N₂ et/ou CO,
et dans lequel le plasma est induit par puissance radiofréquence, dans lequel la puissance radiofréquence comprend une composante de basse fréquence produisant l'accélération d'ions dans le plasma et une composante de haute fréquence maintenant le plasma et contrôlant une densité du plasma, dans lequel la composante de basse fréquence fait référence à toute composante de fréquence dans la plage de 100 kHz à 4 MHz, et la composante de haute fréquence fait référence à toute composante dans la plage de 10 MHz à 100 MHz.

2. Procédé (400) selon la revendication 1, dans lequel un pourcentage du premier composant et du deuxième composant du gaz de traitement est modifié pendant le traitement au plasma.

3. Procédé (400) selon l'une quelconque des revendications précédentes, dans lequel la couche isolante (106) comprend du SiO₂, SICO, SiN ou SiCN.

4. Procédé (400) selon l'une quelconque des revendications précédentes, dans lequel le procédé de traitement au plasma (400) est un procédé sans masque.

5. Procédé (400) selon l'une quelconque des revendications précédentes, dans lequel la couche isolante (106) est une couche conforme.

6. Procédé (400) selon l'une quelconque des revendications précédentes, dans lequel un rapport profondeur/largeur de l'ouverture (102) est au moins de 3.

7. Procédé (400) selon l'une quelconque des revendications précédentes, dans lequel une largeur de l'ouverture (106) est comprise entre 0,1 et 20 micromètres.

8. Procédé (400) selon l'une quelconque des revendications précédentes, dans lequel l'ouverture (106) est une ouverture Through Substrate Via, TSV, (interconnexion traversant le substrat).

9. Procédé (400) selon l'une quelconque des revendications précédentes, le procédé (400) comprenant en outre le retrait de la couche polymère protectrice (118) après le traitement au plasma.

10. Procédé (400) selon l'une quelconque des revendications précédentes, dans lequel le procédé (400) est mis en œuvre en utilisant un dispositif de Reactive Ion Etching, RIE (gravure ionique réactive).
